# EUROPEAN PATENT SPECIFICATION

(11) **EP 3 040 356 B1**
(45) Date of publication and mention of the grant of the patent: **11.10.2017**
(21) Application number: 15160974.0
(22) Date of filing: 26.03.2015
(51) Int. Cl.: C08G 59/40, C08G 59/62, C08K 5/00, C08K 5/49, C08K 5/5317

(54) **HALOGEN-FREE THERMOSETTING RESIN COMPOSITION, PREPREG AND LAMINATE FOR PRINTED CIRCUIT PREPARED FROM THE SAME**
HALOGENFREIE WÄRMEHÄRTENDE HARZZUSAMMENSETZUNG, PREPREG UND LAMINAT FÜR DARAUS HERGESTELLTE LEITERPLATTE
COMPOSITION DE RÉSINE THERMODURCISSABLE SANS HALOGÈNE, PRÉ-IMPRÉGNÉE ET STRATIFIÉE POUR CIRCUIT IMPRIMÉ PRÉPARÉ À PARTIR DE CELUI-CI

(30) Priority: 29.12.2014 CN 201410834617
(43) Date of publication of application: 06.07.2016
(73) Proprietor: Shengyi Technology Co., Ltd., Guangdong 523808 (CN)
(72) Inventor: You, Jiang, 523808 Dongguan City (CN); Huang, Tianhui, 523808 Dongguan City (CN); Yang, Zhongqiang, 523808 Dongguan City (CN)
(74) Representative: Ricker, Mathias

(56) References cited:
- EP-A1- 2 368 930
- WO-A1-2004/044054
- US-A1- 2012 024 580
- US-A1- 2013 316 155
- US-A1- 2014 322 541

## Description

### Technical field

The present invention relates to a halogen-free thermosetting resin composition, and also a prepreg and a laminate for printed circuit prepared from the halogen-free thermosetting resin composition.

### Background art

For conventional laminates for printed circuit, brominated flame retardants, especially tetrabromobisphenol-A epoxy resin, are usually used to achieve flame retardance. Such brominated epoxy resin has better flame retardancy, but will produce hydrogen bromide during combustion. In addition, carcinogens, such as dioxin, dibenzofuran and the like, have been detected in the combustion products of waste electrical and electronic equipment containing halogens, such as bromide, fluorine and the like. Thus the application of brominated epoxy resin has been limited. Two Environmental Directives, Waste Electrical and Electronic Equipment Directive and The Restriction of the use of certain Hazardous substances in Electnical and Electronic Equipment, were formally implemented on July 1, 2006. The development of halogen-free flame-retardant copper clad laminates became the hot spot in the industry, and the cooper clad laminate manufacturers have launched their own halogen-free flame-retardant copper clad laminates in succession.

With the high speed and multifunctional development of information processing of consumer electronic product, the application frequencies are continuously increased. Besides increasing environmental requirements, there are increasingly requirements on low dielectric constant and dielectric dissipation value. Thus it becomes the hot pursuit to decrease Dk/Df in the substrate industry. For conventional FR-4 materials, dicyandiamide is mostly used as the curing agent. Such curing agent has three-level reactive amine, and has better process operability. However, the cured products have a lower thermal decomposition temperature due to its weaker C-N bond which is easy to split under high temperature, so that they cannot meet the requirements on thermal resistance for lead-free processes. In this context, it began to use phenolic resin as the epoxy curing agent in the industry with the large scale implementation of lead-free process in 2006. Phenolic resin has the benzene ring structure of high density, so that the epoxy-cured system has excellent thermal resistance. However, the dielectric properties of the cured products have the tendency of being deteriorated.

An epoxy resin composition comprising an epoxy resin, a reactive phosphonate curing agent, an inorganic filler, an optional polybenzoxazine resin, and an optional co-curing agent is known from WO 2004/044054 A1. In addition, US 2013/316155 A1 describes a halogen-free resin composition applicable to copper clad laminates and printed circuit boards, comprising (A) 100 parts by weight of epoxy resin, (B) 10 to 100 parts by weight of benzoxazine resin, (C) 10 to 100 parts by weight of styrene-maleic anhydride copolymer, and (D) 10 to 90 parts by weight of dicyclopentadiene phenol novolac resin.

Furthermore, US 2014/322541 A1 discloses a halogen-free resin composition suitable for producing a prepreg, comprising (A) 100 parts by weight of epoxy resin, (B) 3 to 15 parts by weight of diaminodiphenyl sulfone, and (C) 5 to 70 parts by weight of phenolic co-hardener. Moreover, EP 2 368 930 A1 discloses a low dielectric resin varnish composition for laminated printed circuit boards, comprising (A) dicyclopentadiene phenolic novolac resin, or (B) at least one type of dicyclopentadiene phenolic novolac epoxy resin, or (C) a dicyclopentadiene-dihydrobenzoxazine resin, or a mixture of (B) and (C), and (D) flame retardant agent, curing agent and accelerating agent solution.

### Contents of the invention

Upon studies, the applicant found that phosphorus-containing bisphenol may be used as the curing agent of epoxy resins, wherein reaction groups include hydroxyl groups and phosphorus units at both sides, without any production of secondary hydroxyl groups during the reaction. The cured products have a high glass transition temperature, and excellent dielectric performance and thermal resistance. In addition, phosphorus-containing bisphenol has a high phosphorus content and has the effects of halogen-free flame retardance when used as the curing agent, so as to greatly decrease the addition amount of flame retardant.

On such a basis, one object of the present invention is to provide a halogen-free thermosetting resin composition, and also a prepreg and a laminate for printed circuit prepared from the halogen-free thermosetting resin composition. The laminate for printed circuit prepared by using such resin composition has a high glass transition temperature, excellent dielectric performance, low water absorption, high thermal resistance and better process workability. In addition, it can also fulfill the halogen-free flame retardance and achieve UL94 V-0.

In order to achieve such object, the inventor conducted extensive studies and found that the composition obtained by suitably mixing halogen-free epoxy resin, phosphorus-containing bisphenol, dicyclopentadiene novolac, phosphorus-containing flame retardant, and optionally other substances can achieve such object.

That is to say, the following technical solution is used in the present invention: a halogen-free thermosetting resin composition, comprising the following four substances as the essential components, based on 100 parts by weight of organic solids,
(A) from 30 to 60 parts by weight of a halogen-free epoxy resin,
(B) from 5 to 30 parts by weight of a first curing agent of phosphorus-containing bisphenol,
(C) from 5 to 30 parts by weight of a second curing agent of dicyclopentadiene novolac; and
(D) a phosphorus-containing flame retardant;
wherein the phosphorus-containing bisphenol has the following structure 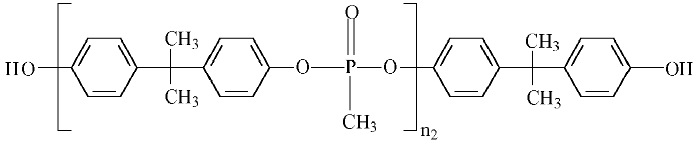 wherein n₂ is an integer of 2 to 20, *e.g.* 3, 4, 5, 6, 7, 8, 9, 10, 11, 12, 13, 14, 15, 16, 17, 18 or 19, preferably an integer of from 3 to 10.

The halogen-free thermosetting resin composition of the present invention uses halogen-free epoxy resin having specific molecular structure, has higher functionality and better dielectric performance. The cured products have a higher Tg and a low water absorption.

The halogen-free thermosetting resin composition of the present invention uses phosphorus-containing biphenol as the first curing agent. Such phosphorus-containing bisphenol has a high structural symmetry. Moreover, phosphorus in the molecule may react with secondary hydroxyl in epoxy resin, and the cured products have a high Tg and excellent dielectric performance. In addition, such phosphorus-containing bisphenol has a high phosphorus content, and has the effect of halogen-free flame retardance.

In addition, the halogen-free thermosetting resin composition of the present invention uses dicyclopentadiene novolac as the second curing agent, which sufficiently takes the advantages of excellent dielectric performance and low water absorption due to more dicyclopentadiene structures in the molecule thereof, so as to greatly decrease the water absorption of the cured products without sacrificing the Tg and dielectric performance of the cured products.

By using the synergistic effects between phosphorus-containing bisphenol and dicyclopentadiene novolac, the present invention can notably increase the glass transition temperature and thermal resistance of the prepreg and laminate for printed circuit prepared by using such resin composition, and make them have excellent dielectric performance, low water absorption and better process workability. In addition, it can also fulfill the halogen-free flame retardance and achieve UL94 V-0.

Additionally, phosphorus-containing bisphenol and epoxy resin have a high curing reaction rate, while dicyclopentadiene novolac and epoxy resin have a low curing reaction rate. Phosphorus-containing bisphenol and dicyclopentadiene novolac are simultaneously used to cure epoxy resin, so as to achieve proper curing reaction rate and make it easy to control, and to greatly decrease the difficulties of the production and processing.

Each component is detailedly disclosed as follows.

For component (A) in the present invention, i.e. halogen-free epoxy resin, the amount thereof is suggested to be properly from 30 to 60 parts by weight, *e.g.* 32, 34, 36, 38, 40, 42, 44, 46, 48, 50, 52, 54, 56 or 58 parts by weight.

Preferably, the halogen-free epoxy resin is one selected from or the mixture of at least two selected from bisphenol-A epoxy resin, bisphenol-F epoxy resin, o-cresol novolac epoxy resin, bisphenol-A novolac epoxy resin, trisphenol novolac epoxy resin, dicyclopentadiene novolac epoxy resin, biphenyl novolac epoxy resin, alkylbenzene novolac epoxy resin and naphthol novolac epoxy resin. The aforesaid epoxy resins all are halogen-free.

Preferably, the halogen-free epoxy resin is selected from the epoxy resin having the following structure, 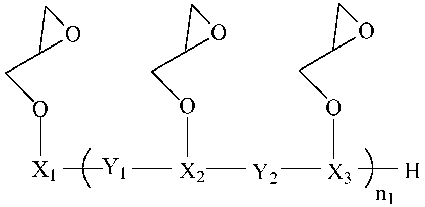
wherein, X₁, X₂ and X₃ are each independently selected from 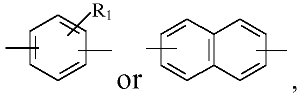 R₁ is selected from hydrogen atom, substituted or unsubstituted C1-C5 (*e.g.* C2, C3, C4) linear alkyl, and substituted or unsubstituted C1-C5 (*e.g.* C2, C3, C4) branched alkyl;
Y₁ and Y₂ are each independently selected from single bonds, -CH₂-, 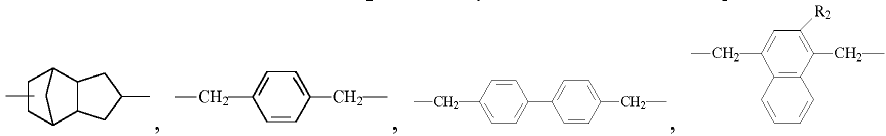 and 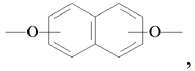 wherein n₁ is an integer from 1 to 10, *e.g.* 2, 3, 4, 5, 6, 7, 8 or 9; R₂ is selected from hydrogen atom, substituted or unsubstituted C1-C5 (*e.g.* C2, C3, C4) linear alkyl, and substituted or unsubstituted C1-C5(*e.g.* C2, C3, C4) branched alkyl.

The halogen-free thermosetting resin composition of the present invention has the aforesaid specific molecular structure, has a higher functionality and better dielectric performance. The cured products thereof have a higher Tg and a low water absorption.

Component (B) in the present invention is a phosphorus-containing bisphenol curing agent having the following structure 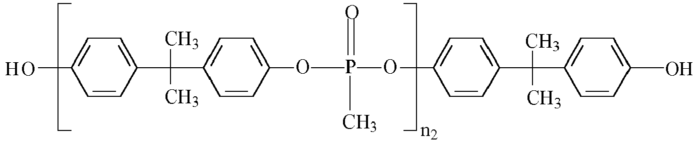 wherein n₂ is an integer of 2 to 20, *e.g.* 3, 4, 5, 6, 7, 8, 9, 10, 11, 12, 13, 14, 15, 16, 17, 18 or 19, preferably an integer of from 3 to 10.

Preferably, the phosphorus-containing bisphenol has a weight average molecular weight of from 1000 to 6500, preferably from 1000 to 4500, more preferably from 1000 to 3000. When the weight average molecular weight is less than 1000, the cured products have a low Tg and a worse thermal resistance; when the weight average molecular weight is higher than 6500, the phosphorus-containing bisphenol has a worse solubility in organic solvents, so that a better and homogeneous varnish cannot be obtained, and the process requirements on the copper-clad plates cannot be met.

It is suggested that the phosphorus-containing bisphenol in the present invention can be added in an amount of from 5 to 30 parts by weight, *e.g*. 6, 7, 9, 11, 12, 13, 15, 17, 18, 19, 21, 23, 24, 25, 27, 29 or 30 parts by weight. If the addition amount is too less, there is no obvious effect on the increase of the glass transition temperature and dielectric performance of the cured products; if the addition amount is too high, the cured products have a higher water absorption.

Component (C) in the present invention, *i.e*. the second curing agent, is dicyclopentadiene novolac.

Preferably, the dicyclopentadiene novolac has the following structure 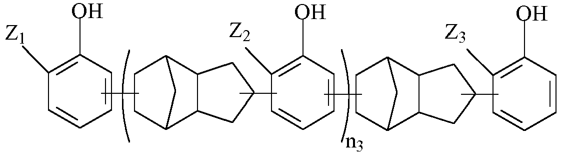 wherein Z₁, Z₂ and Z₃ are independently selected from -H, -CH₃, -C₂H₅ and -C(CH₃)₃; n3 is an integer from 0 to 7, *e.g.* 1, 2, 3, 4, 5 or 6.

It is suggested that the component (C) dicyclopentadiene novolac curing agent in the present invention can be added in an amount of from 10 to 30 parts by weight, *e.g.* 5, 7, 8, 9, 11, 13, 14, 15, 17, 19, 20, 21, 23, 25, 26, 27 or 29 parts by weight. In the structure of dicyclopentadiene novolac, dicyclopentadiene ring has excellent dielectric performance, but a low binding force and is easy to combust. If the addition amount is too less, the cured products have a worse dielectric performance and a high water absorption; if the addition amount is too high, the cured products have a low binding force and worse flame retardant property.

Component (D) in the present invention, i.e. phosphorus-containing flame retardant, makes the resin composition have the flame retardant properties and meet the UL 94 V-0 requirements. The addition amount of the flame retardant is determined on the basis that the flame retardant properties of the cured products meet the requirements of UL 94 V-0 grade, and is not specially limited. Preferably, based on 100 parts of weight of the addition amount of the sum of components (A), (B) and (C), the component (D) is added in an amount of from 5 to 50 parts by weight, , *e.g.* 6, 11, 16, 21, 26, 31, 36, 41 or 46, preferably from 10 to 30 parts by weight.

Preferably, the phosphorus-containing flame retardant is one selected from or the mixture of at least two selected from tri-(2,6-dimethylphenyl)-phosphine, 10-(2,5-dihydroxylphenyl)-9,10-dihydro-9-oxa-10-phosphaphenanthrene -10-oxide, 2,6-di-(2,6-dimethylphenyl) phosphine benzene, 10-phenyl -9,10-dihydro -9-oxa-10- phosphaphenanthrene -10-oxide, phenoxyphosphazene compound, phosphate, polyphosphate, polyphosphonate and phosphonate-carbonate copolymers.

Preferably, the halogen-free thermosetting resin composition of the present invention further comprises (E) a curing accelerator, which is not specially defined, except catalyzing the reaction of epoxy functional groups and lowering the reaction temperature of the curing system, and is preferably one selected from or the mixture of at least two selected from imidazole compounds, derivatives of imidazole compounds, piperidines, lewis acid and triphenylphosphine. The imidazole compounds are one selected from or the mixture of at least two selected from 2-methylimidazole, 2-ethyl-4-methylimidazole, 2-phenylimidazole and 2-undecylimidazole. The piperidines are one selected from or the mixture of at least two selected from 2,3-diamino piperidine, 2,5-diamino piperidine, 2,6- diamino piperidine, 2-amino-3-methyl piperidine, 2-amino-4-methyl piperidine, 2-amino-3-nitro piperidine, 2-amino-5-nitro piperidine and 2-amino-4,4-dimethyl piperidine.

Preferably, based on 100 parts of weight of the addition amount of the sum of components (A), (B), (C) and (D), the component (E) is added in an amount of from 0.01 to 1 part by weight, *e.g.* 0.05, 0.1, 0.15, 0.2, 0.25, 0.3, 0.35, 0.4, 0.45, 0.5, 0.55, 0.6, 0.65, 0.7, 0.75, 0.8, 0.85, 0.9 or 0.95 part by weight, preferably from 0.05 to 0.8 part by weight, more preferably from 0.05 to 0.6 part by weight.

Preferably, the halogen-free thermosetting resin composition of the present invention further comprises (F) a filler, which is added as required, and the amount of which is not specially limited. The filler is selected from organic fillers and inorganic fillers, preferably from inorganic fillers, more preferably surface-treated inorganic fillers, most preferably surface-treated silica.

The surface-treated surface treating agent is one selected from or the mixture of at least two selected from a silane coupling agent, a silicone oligomer and a titanate coupling agent.

Based on 100 parts by weight of the inorganic fillers, the surface treating agent is in an amount of from 0.1 to 5.0 parts by weight, *e.g.* 0.4, 0.8, 1.2, 1.6, 2, 2.4, 2.8, 3.2, 3.6, 4, 4.4 or 4.8 parts by weight, preferably from 0.5 to 3.0 parts by weight, more preferably from 0.75 to 2.0 parts by weight.

Preferably, the inorganic fillers are one selected from or the mixture of at least two selected from non-metal oxides, metal nitrides, non-metal nitrides, inorganic hydrates, inorganic salts, metal hydrates and inorganic phosphorus, more preferably are one selected from or the mixture of at least two selected from fused silica, crystalline silica, spherical silica, hollow silica, aluminum hydroxide, alumina, talc, aluminum nitride, boron nitride, silicon carbide, barium sulfate, barium titanate, strontium titanate, calcium carbonate, calcium silicate and mica.

Preferably, the organic fillers are one selected from or the mixture of at least two selected from polytetrafluoroethylene powder, polyphenylene sulfide and polyether sulfone powders.

Preferably, there is no special limitation for the shape and particle size of the fillers. Preferably, the fillers have a median particle diameter of from 0.01 to 50 µm, *e.g.* 1, 6, 11, 16, 21, 26, 31, 36, 41 or 46µm, preferably from 0.01 to 20 µm, more preferably from 0.1 to 10 µm. The fillers having such particle size are easy to disperse in the varnish.

In addition, the addition amount of the component (F) is not specially limited. Based on 100 parts of weight of the addition amount of the sum of components (A), (B), (C) and (D), the component (F) is added in an amount of from 5 to 300 parts by weight, *e.g.* 10, 30, 50, 70, 90, 110, 130, 150, 170, 190, 210, 230, 250, 270 or 290 parts by weight, preferably from 5 to 200 parts by weight, more preferably from 5 to 150 parts by weight.

The wording "comprise" in the invention means that, besides said components, there may be other components which endow the halogen-free thermosetting resin composition with different properties. In addition, the wording "comprise" in the present invention may be replaced with "is/are" or "consist of" in a close manner.

For example, the halogen-free thermosetting resin composition may comprise various additives. As specific examples, antioxidants, thermal stabilizers, antistatic agents, ultraviolet light absorbers, pigments, colorants or lubricants may be used. These additives may be used separately or in combination.

The halogen-free thermosetting resin composition of the present invention is conventionally prepared by adding the solids first, then adding liquid solvents, stirring till the solids are completely dissolved, then adding liquid resin and optionally the curing accelerator, continuing to homogeneously stir.

The solvents in the present invention are not specifically limited. As specific examples, alcohols, such as methanol, ethanol, butanol and the like, ethers, such as ethyl cellosolve, butyl cellosolve, glycol methylether, carbitol, butyl carbitol, and the like, ketones, such as acetone, butanone, methylethyl ketone, cyclohexanone and the like, aromatic hydrocarbons, such as toluene, xylene, and the like, esters, such as ethyl acetate, ethoxyethyl acetate, and nitrogen-containing solvents, such as N,N-dimethylformamide, N,N-dimethylacetamide and the like can be used. The aforesaid solvents can be used separately, or in combination. Ketones, such as acetone, butanone, methylethyl ketone, cyclohexanone and the like, are preferred. The addition amount of said solvents is determined by those skilled in the art according to their experiences, and it is better to make the resin varnish reach the suitable viscosity.

One object of the present invention is to provide a prepreg comprising a reinforcing material and a halogen-free thermosetting resin composition above which is attached thereon after impregnation and drying.

The reinforcing material used therein is not specially limited. It may be organic fibers, inorganic fiber woven fabrics or non-woven fabrics. Said organic fibers may be aramid fiber non-woven fabrics. Said inorganic fiber woven fabrics may be E-glass fabrics, D-glass fabrics, S-glass fabrics, T-glass fabrics, NE-glass fabrics, or quartz fabrics. The thickness of said reinforcing material is not specially limited. For better size stability of laminates, said woven fabrics and non-woven fabrics have a thickness of preferably from 0.01 to 0.2 mm, and are better to be fibrillated and surface-treated with silane coupling agent. In order to provide better water resistance and thermal resistance, said silane coupling agent is preferably one selected from or the mixture of at least two selected from an epoxy silane coupling agent, an amino-based silane coupling agent or an ethylene silane coupling agent. The above halogen-free thermosetting resin composition is impregnated with the reinforcing material and baked at 100-250°C for 1-15 min to obtain said prepreg.

One object of the present invention is to provide a laminate comprising at least one prepreg above. The laminate is obtained by binding at least one prepreg together via heating and pressing.

The laminate is prepared by curing in a thermocompressor at a temperature of from 150-250°C and a pressure of from 10 to 60 Kg/cm².

One object of the present invention is to provide a halogen-free high-frequency circuit board, comprising at least one prepreg above and metal foils coated on one or two sides of the laminated prepreg.

The metal foils are copper foils, nickel foils, aluminum foils, SUS foils, and the like, and the materials thereof are not limited.

As compared with the prior art, the present invention has the following beneficial effects.

In the present invention, the halogen-free thermosetting resin composition uses phosphorus-containing biphenol as the first curing agent. Such phosphorus-containing bisphenol has a high structural symmetry. Moreover, phosphorus in the molecule may react with secondary hydroxyl in epoxy resin, and the cured products have a high Tg and excellent dielectric performance. In addition, such phosphorus-containing bisphenol has a high phosphorus content, and has the effect of halogen-free flameretardance.

Moreover, the halogen-free thermosetting resin composition of the present invention uses dicyclopentadiene novolac as the second curing agent, which sufficiently takes the advantages of excellent dielectric performance and low water absorption due to more dicyclopentadiene structures in the molecules thereof, so as to greatly decrease the water absorption of the cured products without sacrificing the Tg and dielectric performance of the cured products.

By using the synergistic effects between phosphorus-containing bisphenol and dicyclopentadiene novolac resin, the present invention can notably increase the glass transition temperature and thermal resistance of the prepreg and laminated for printed circuit prepared by using such resin composition, and make them have excellent dielectric performance, low water absorption and better process workability. In addition, it can also fulfill the halogen-free flame retardance and achieve UL94 V-0.

The prepreg and laminate for printed circuit prepared from the halogen-free thermosetting resin composition according to the present invention have high glass transition temperature, excellent dielectric properties, low water absorption and high thermal resistance, and can fulfill halogen-free flame retardance and achieve the grade of UL94 V-0.

### Embodiments

The technical solution of the present invention is further disclosed by the following embodiments.

For the laminates (8 prepregs, the reinforcing material which has the model No.2116 and a thickness of 0.08mm) for printed circuit prepared according to the aforesaid disclosure, the glass transition temperature, dielectric constant, dielectric dissipation factor, peel strength, water absorption, thermal resistance and flame retardancy were tested, which were further disclosed and described detailedly in the following examples.

Please refer to Examples 1-8 and Comparison Examples 1-8. If no special instructions, parts thereafter refer to parts by weight, and % refers to "wt%".
(A) Halogen-free epoxy resin
(A-1) Dicyclopentadiene epoxy resin HP-7200H (produced by DIC, Japan, and having an EEW: 275g/eq)
(A-2) biphenyl novolac epoxy resin NC-3000H (produced by Nippon Kayaku Co Ltd and having an EEW: 288g/eq)

(B) First curing agent
(B-1) Phosphorus-containing bisphenol OL1001 (produced by FRX Polymers, U.S., having a phosphorus content of 8.5%)
(B-2) Polyphosphonate OL5000 (produced by FRX Polymers, U.S., having a phosphorus content of 10.8%), the structural formula being as follows,

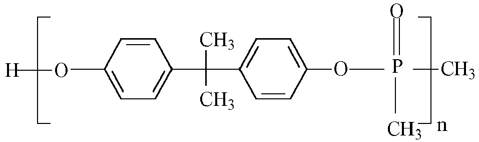

(C) Second curing agent
(C-1) Dicyclopentadiene novolac DP9110A70 (produced by Changchun, Taiwan)
(C-2) Active ester curing agent HPC-8000-65T (produced by Dainippon Ink)
(C-3) Linear novolac 2812 (produced by MOMENTIVE, Republic of Korea)

(D) Phosphorus-containing flame retardant Phosphorus-containing novolac XZ92741 (produced by DOW, U.S., and having a phosphorus content of 9%)
(E) Accelerator: 2-ethyl-4-methylimidazole (produced by Shikoku Chemicals, Japan)
(F) Filler: fused silica (having an average particle diameter of from 1 to 10 µm and a purity of more than 99%)

**Table 1 The formula composition and physical property data of each example**

| | Exp.1 | Exp.2 | Exp.3 | Exp.4 | Exp.5 | Exp.6 | Exp.7 | Exp.8 |
|---|---|---|---|---|---|---|---|---|
| A-1 | 30 | 45 | 60 | 50 | 50 | --- | --- | --- |
| A-2 | --- | --- | --- | --- | --- | 30 | 45 | 60 |
| B-1 | 15 | 20 | 24 | 5 | 30 | 12 | 20 | 24 |
| B-2 | --- | --- | --- | --- | --- | --- | --- | --- |
| C-1 | 30 | 25 | 6 | 25 | 5 | 33 | 25 | 6 |
| C-2 | --- | --- | --- | --- | --- | --- | --- | --- |
| C-3 | --- | --- | --- | --- | --- | --- | --- | --- |
| D | 25 | 10 | 10 | 20 | 15 | 25 | 10 | 10 |
| E | q.s. | q.s. | q.s. | q.s. | q.s. | q.s. | q.s. | q.s. |
| F | 40 | 40 | 40 | 40 | 40 | 40 | 40 | 40 |
| Glass transition temperature (DSC) °C | 170 | 173 | 179 | 175 | 179 | 172 | 172 | 177 |
| Dielectric constant (1GHz) | 3.65 | 3.59 | 3.58 | 3.60 | 3.56 | 3.63 | 3.61 | 3.59 |
| Dielectric dissipation (1GHz) | 0.0078 | 0.0075 | 0.0071 | 0.0081 | 0.0069 | 0.0071 | 0.0068 | 0.0080 |
| Peel strength (N/mm) | 1.31 | 1.35 | 1.36 | 1.28 | 1.33 | 1.30 | 1.30 | 1.37 |
| Water absorption (%) | 0.07 | 0.07 | 0.08 | 0.07 | 0.08 | 0.07 | 0.07 | 0.07 |
| Solder dipping 288°C, s | >120 | >120 | >120 | >120 | >120 | >120 | >120 | >120 |
| Incombustibility | V-0 | V-0 | V-0 | V-0 | V-0 | V-0 | V-0 | V-0 |

**Table 2 The formula composition and physical property data of Comparison Examples 1-6**

| | Com.Exp.1 | Com.Exp.2 | Com.Exp.3 | Com.Exp.4 | Com.Exp.5 | Com.Exp.6 |
|---|---|---|---|---|---|---|
| A-1 | 45 | 45 | 45 | 45 | 45 | --- |
| A-2 | --- | --- | --- | --- | --- | 45 |
| B-1 | 45 | --- | 20 | 20 | --- | --- |
| B-2 | --- | --- | --- | --- | 20 | 20 |
| C-1 | --- | 45 | --- | --- | 25 | 25 |
| C-2 | --- | --- | 25 | --- | --- | --- |
| C-3 | --- | --- | --- | 25 | --- | --- |
| D | 10 | 10 | 10 | 10 | 10 | 10 |
| E | q.s. | q.s. | q.s. | q.s. | q.s. | q.s. |
| F | 40 | 40 | 40 | 40 | 40 | 40 |
| Glass transition temperature (DSC) °C | 178 | 174 | 162 | 176 | 149 | 152 |
| Dielectric constant (1GHz) | 3.68 | 3.52 | 3.79 | 3.98 | 3.91 | 3.93 |
| Dielectric dissipation (1GHz) | 0.0060 | 0.0095 | 0.0091 | 0.0102 | 0.0095 | 0.0088 |
| Peel strength (N/mm) | 1.51 | 0.95 | 1.35 | 1.35 | 1.38 | 1.36 |
| Water absorption (%) | 0.17 | 0.06 | 0.14 | 0.08 | 0.15 | 0.15 |
| Solder dipping 288°C, s | 75 | >120 | >120 | >120 | >120 | >120 |
| Incombustibility | V-0 | V-1 | V-0 | V-0 | V-0 | V-0 |

**Table 3 The formula composition and physical property data of Comparison Examples 7-8**

| | Com.Exp.7 | Com.Exp.8 |
|---|---|---|
| A-1 | 45 | 45 |
| A-2 | --- | --- |
| B-1 | 20 | --- |
| B-2 | --- | --- |
| C-1 | --- | 25 |
| C-2 | --- | --- |
| C-3 | --- | --- |
| D | 10 | 10 |
| E | q.s. | q.s. |
| F | 40 | 40 |
| Glass transition temperature (DSC) °C | 182 | 171 |
| Dielectric constant (1GHz) | 3.51 | 3.67 |
| Dielectric dissipation (1GHz) | 0.0059 | 0.0087 |
| Peel strength (N/mm) | 1.38 | 1.15 |
| Water absorption (%) | 0.17 | 0.06 |
| Solder dipping 288°C, s | 91 | >120 |
| Incombustibility | V-0 | V-1 |

The aforesaid properties are tested by
(a) Glass transition temperature (Tg): measuring by differential scanning calorimetry (DSC) according to DSC method specified in IPC-TM-650 2.4.25.
(b) Dielectric constant and dielectric dissipation factor: measuring the dielectric constant and dielectric dissipation factor at 1 GHz by the resonance method using a strip line according to IPC-TM-650 2.5.5.5.
(c) Peel strength: measuring the peel strength of the metal cover coat according to the test conditions of "thermal stress" in IPC-TM-650 2.4.8.
(d) Water absorption: measuring according to IPC-TM-650 2.6.2.1.
(e) Solder dipping: observing the layering and blistering time according to IPC-TM-650 2.4.13.1.
(f) Incombustibility: measuring according to UL 94 vertical burning method.

According to the physical property datas in Tables 1, 2 and 3, phosphorus-containing bisphenol was used separately in Comparison Examples 1 and 7 to cure dicyclopentadiene epoxy resin. The resultant laminate had a high Tg and excellent dielectric performance, peel strength and flame retardant property, high water absorption, but worse thermal resistance. Dicyclopentadiene novolac was used separately in Comparison Examples 2 and 8 to cure dicyclopentadiene epoxy resin. The resultant laminate had a high Tg and excellent dielectric performance and thermal resistance, but low water absorption, low peel strength and worse flame retardancy. Phosphorus-containing bisphenol and active ester were used in Comparison Example 3 to co-cure dicyclopentadiene epoxy resin. The resultant laminate had a high Tg, better dielectric performance, and high water absorption. Phosphorus-containing bisphenol and linear novolac were used in Comparison Example 4 to co-cure dicyclopentadiene epoxy resin. The sheet materials had high dielectric constant and high dielectric dissipation, so that they cannot meet the requirements of laminates on the dielectric performance in thermosetting high speed field. Polyphosphonate and dicyclopentadiene novolac were used in Comparison Examples 5 and 6 to co-cure dicyclopentadiene epoxy resin and biphenyl novolac epoxy resin respectively. The resultant laminate had a low Tg, worse dielectric performance and high water absorption. Phosphorus-containing bisphenol was used separately in Comparison Example 7 to cure dicyclopentadiene epoxy resin. The resultant laminate had a high glass transition temperature, excellent dielectric performance, and high water absorption, but worse thermal resistance. Dicyclopentadiene novolac was used separately in Comparison Example 8 to cure dicyclopentadiene epoxy resin. The resultant laminate had a high glass transition temperature, better dielectric performance, low water absorption, better thermal resistance, but low peel strength and worse flame retardant property. In Examples 1-8, halogen-free epoxy resin was used as the main part and co-cured with phosphorus-containing bisphenol and dicyclopentadiene novolac. The resultant laminate had a high glass transition temperature, excellent dielectric performance, high thermal resistance, low water absorption. The laminate not only fulfills halogen-free flame retardance, but also achieves the grade of UL94 V-0.

As stated above, the laminate for printed circuit of the present invention, as compared with general laminates, has higher glass transition temperature, more excellent dielectric properties, wet resistance and thermal resistance and is suitable for high-frequency field. In addition, the halogen content can achieve the V-0 standard in the incombustibility test UL94 within the scope of JPCA halogen-free standard requirements, and have the effectiveness of environmental protection.

The applicant declares that, the present invention discloses the detailed method of the present invention by the aforesaid examples, but the present invention is not limited by the detailed method, *i.e.* it does not mean that the present invention cannot be fulfill unless the aforesaid detailed method is used.

## Claims

1. A halogen-free thermosetting resin composition, comprising, based on 100 parts by weight of organic solids,
(A) from 30 to 60 parts by weight of a halogen-free epoxy resin;
(B) from 5 to 30 parts by weight of a first curing agent of phosphorus-containing bisphenol;
(C) from 5 to 30 parts by weight of a second curing agent of dicyclopentadiene novolac; and
(D) a phosphorus-containing flame retardant;
wherein the phosphorus-containing bisphenol has the following structure 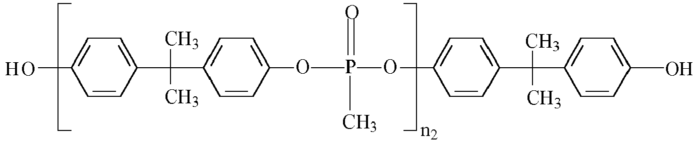 wherein n₂ is an integer of 2 to 20, preferably an integer of from 3 to 10;
preferably, the phosphorus-containing bisphenol has a weight average molecular weight of from 1000 to 6500, preferably from 1000 to 4500, more preferably from 1000 to 3000.

2. The halogen-free thermosetting resin composition according to claim 1, **characterized in that** the halogen-free epoxy resin is one selected from or the mixture of at least two selected from bisphenol-A epoxy resin, bisphenol-F epoxy resin, o-cresol novolac epoxy resin, bisphenol-A novolac epoxy resin, trisphenol novolac epoxy resin, dicyclopentadiene novolac epoxy resin, biphenyl novolac epoxy resin, alkylbenzene novolac epoxy resin and naphthol novolac epoxy resin;
preferably, the halogen-free epoxy resin is selected from the epoxy resin having the following structure, 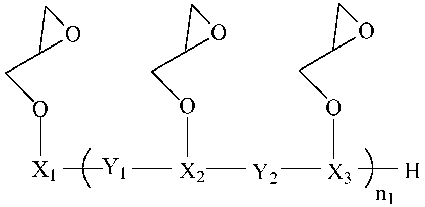 wherein, X₁, X₂ and X₃ are each independently selected from 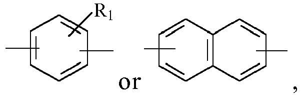 R₁ is selected from hydrogen atom, substituted or unsubstituted C1-C5 linear alkyl, and substituted or unsubstituted C1-C5 branched alkyl;
Y₁ and Y₂ are each independently selected from single bonds, -CH₂-, 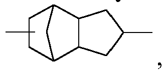 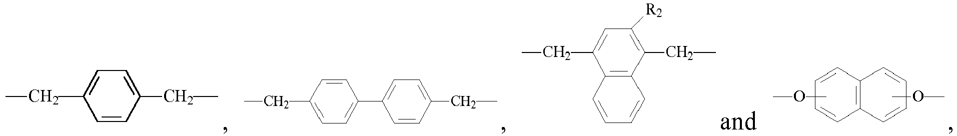 wherein n₁ is an integer from 1 to 10; R₂ is selected from hydrogen atom, substituted or unsubstituted C1-C5 linear alkyl, and substituted or unsubstituted C1-C5 branched alkyl.

3. The halogen-free thermosetting resin composition according to claim 1 or 2, **characterized in that** the dicyclopentadiene novolac has the following structure 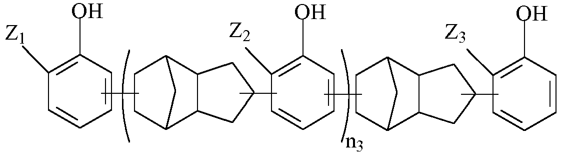 wherein Z₁, Z₂ and Z₃ are independently selected from-H, -CH₃, -C₂H₅ and -C(CH₃)₃; n3 is an integer from 0 to 7.

4. The halogen-free thermosetting resin composition according to one of claims 1-3, **characterized in that**, based on 100 parts of weight of the addition amount of the sum of components (A), (B) and (C), the component (D) is added in an amount of from 5 to 50 parts by weight, preferably from 10 to 30 parts by weight;
preferably, the phosphorus-containing flame retardant is one selected from or the mixture of at least two selected from
tri-(2,6-dimethylphenyl)-phosphine, 10-(2,5-dihydroxylphenyl)-9,10-dihydro -9-oxa-10-phosphaphenanthrene-10-oxide, 2,6-di-(2,6-dimethylphenyl)phosphine benzene, 10-phenyl-9,10-dihydro-9-oxa-10-phosphaphenanthrene-10-oxide, phenoxyphosphazene compound, phosphate, polyphosphate, polyphosphonate and phosphonate-carbonate copolymers.

5. The halogen-free thermosetting resin composition according to one of claims 1-4, **characterized in that** the he halogen-free thermosetting resin composition further comprises (E) a curing accelerator;
preferably, the curing accelerator is one selected from or the mixture of at least two selected from imidazole compounds, derivatives of imidazole compounds, piperidines, lewis acid and triphenylphosphine;
preferably, the imidazole compounds are one selected from or the mixture of at least two selected from 2-methylimidazole, 2-ethyl-4-methylimidazole, 2-phenylimidazole and 2-undecylimidazole;
preferably, the piperidines are one selected from or the mixture of at least two selected from 2,3-diamino piperidine, 2,5- diamino piperidine, 2,6- diamino piperidine, 2-amino-3-methyl piperidine, 2-amino-4-methyl piperidine, 2-amino-3-nitro piperidine, 2-amino-5-nitro piperidine and 2-amino-4,4-dimethyl piperidine;
preferably, based on 100 parts of weight of the addition amount of the sum of components (A), (B), (C) and (D), the component (E) is added in an amount of from 0.01 to 1 part by weight, preferably from 0.05 to 0.8 part by weight, more preferably from 0.05 to 0.6 part by weight.

6. The halogen-free thermosetting resin composition according to one of claims 1-5, **characterized in that** the halogen-free thermosetting resin composition further comprises (F) a filler;
preferably, the filler is selected from organic fillers and inorganic fillers, preferably from inorganic fillers, more preferably surface-treated inorganic fillers, most preferably surface-treated silica;
preferably, the surface-treated surface treating agent is one selected from or the mixture of at least two selected from a silane coupling agent, a silicone oligomer and a titanate coupling agent;
preferably, based on 100 parts by weight of the inorganic fillers, the surface treating agent is in an amount of from 0.1 to 5.0 parts by weight, preferably from 0.5 to 3.0 parts by weight, more preferably from 0.75 to 2.0 parts by weight;
preferably, the inorganic fillers are one selected from or the mixture of at least two selected from non-metal oxides, metal nitrides, non-metal nitrides, inorganic hydrates, inorganic salts, metal hydrates and inorganic phosphorus, more preferably are one selected from or the mixture of at least two selected from fused silica, crystalline silica, spherical silica, hollow silica, aluminum hydroxide, alumina, talc, aluminum nitride, boron nitride, silicon carbide, barium sulfate, barium titanate, strontium titanate, calcium carbonate, calcium silicate and mica;
preferably, the organic fillers are one selected from or the mixture of at least two selected from polytetrafluoroethylene powder, polyphenylene sulfide and polyether sulfone powders;
preferably, the fillers have a median particle diameter of from 0.01 to 50 µm, preferably from 0.01 to 20 µm, more preferably from 0.1 to 10 µm;
preferably, based on 100 parts of weight of the addition amount of the sum of components (A), (B), (C) and (D), the component (F) is added in an amount of from 5 to 300 parts by weight, preferably from 5 to 200 parts by weight, more preferably from 5 to 150 parts by weight.

7. A prepreg comprising a reinforcing material and a halogen-free thermosetting resin composition according to one of claims 1-6 which is attached thereon after impregnation and drying.

8. A laminate comprising at least one prepreg according to claim 7.

9. A halogen-free high-frequency circuit board, comprising at least one prepreg according to claim 7 and metal foils coated on one or two sides of the laminated prepreg.

## Patentansprüche

1. Halogenfreie in Wärme aushärtende Harzzusammensetzung, welche bezogen auf 100 Gewichtsteile an organischen Feststoffen aufweist:
(A) 30 bis 60 Gewichtsteile eines halogenfreien Epoxidharzes,
(B) 5 bis 30 Gewichtsteile eines ersten Härtungsmittels aus einem Phosphor enthaltenden Bisphenol,
(C) 5 bis 30 Gewichtsteile eines zweiten Härtungsmittels aus einem Dicyclopentadien-Novolak und
(D) ein Phosphor enthaltendes Flammschutzmittel,
wobei das Phosphor enthaltende Bisphenol die folgende Struktur aufweist 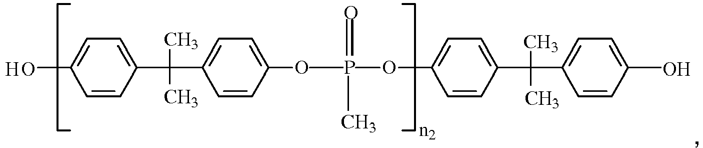 wobei n₂ eine ganze Zahl von 2 bis 20 ist und es bevorzugt eine ganze Zahl von 3 bis 10 ist,
wobei bevorzugt das Phosphor enthaltende Bisphenol ein im Gewicht gemitteltes Molekulargewicht von 1000 bis 6500, bevorzugt von 1000 bis 4500 und besonders bevorzugt von 1000 bis 3000 aufweist.

2. Halogenfreie in Wärme aushärtende Harzzusammensetzung nach Anspruch 1, **dadurch gekennzeichnet, dass** das halogenfreie Epoxidharz eines ist, das aus einer Substanz oder aus einer Mischung aus mindestens zwei Substanzen ausgewählt worden ist, die aus einem Bisphenol-A-Epoxidharz, einem Bisphenol-F-Epoxidharz, einem o-Kresolnovolak- Epoxidharz, einem Bisphenol-A-Novolak-Epoxidharz, einem Trisphenol-Novolac-Epoxidharz, einem Dicyclopentadien-Novolac-Epoxidharz, einem Biphenyl-Novolac-Epoxidharz, einem Alkylbenzol-Novolac-Epoxidharz und einem Naphthol-Novolac-Epoxidharz ausgewählt worden sind,
wobei bevorzugt das halogenfreie Epoxidharz aus einem Epoxidharz mit der folgenden Struktur ausgewählt worden ist, 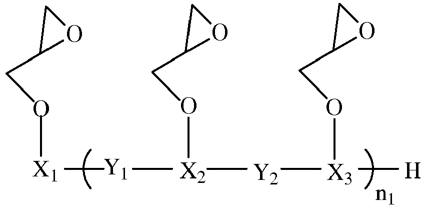 wobei X₁, X₂ und X₃ jeweils unabhängig voneinander aus einem 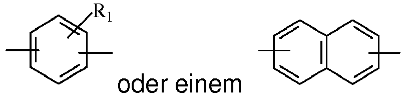 ausgewählt worden sind, wobei R₁ aus einem Wasserstoffatom, einem substituierten oder unsubstituierten linearen C1-C5-Alkyl und einem substituierten oder unsubstituierten verzweigten C1-C5-Alkyl ausgewählt worden ist,
wobei Y₁ und Y₂ jeweils unabhängig voneinander aus Einfachbindungen, 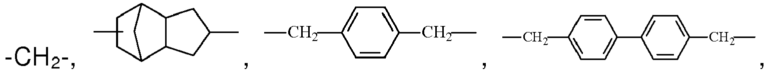 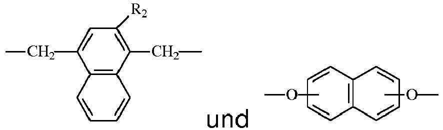 ausgewählt worden sind, wobei n₁ eine ganze Zahl von 1 bis 10 ist und wobei R₂ aus einem Wasserstoffatom, einem substituierten oder unsubstituierten linearen C1-C5-Alkyl und einem substituierten oder unsubstituierten verzweigten C1-C5-Alkyl ausgewählt worden ist.

3. Halogenfreie in Wärme aushärtende Harzzusammensetzung nach Anspruch 1 oder 2, **dadurch gekennzeichnet**, das der Dicyclopentadien-Novolak die folgende Struktur aufweist: 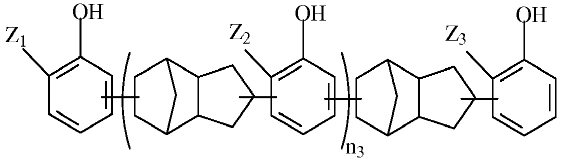 wobei Z₁, Z₂ und Z₃ unabhängig voneinander aus einem -H, einem -CH₃, einem -C₂H₅ und einem -C(CH₃)₃ ausgewählt worden sind und wobei n₃ eine ganze Zahl von 0 bis 7 ist.

4. Halogenfreie in Wärme aushärtende Harzzusammensetzung nach einem der Ansprüche 1 bis 3, **dadurch gekennzeichnet, dass** bezogen auf 100 Gewichtsteile der hinzugefügten Menge der Summe der Komponenten (A), (B) und (C) die Komponente (D) in einer Menge von 5 bis 50 Gewichtsteilen und bevorzugt in einer Menge von 10 bis 30 Gewichtsteilen hinzugefügt wird,
wobei bevorzugt das Phosphor enthaltende Flammschutzmittel ausgewählt worden ist als eine Substanz oder als die Mischung von mindestens zwei Substanzen, die aus einem Tri-(2,6-dimethylphenyl)-Phosphin, einem 10-(2,5-Dihydroxylphenyl)-9,10-Dihydro-9-oxa-10-Phosphaphenanthren-10-Oxid, einem 2,6-Di-(2,6-Dimethylphenyl)Phosphinbenzol, einem 10-Phenyl-9,10-Dihydro-9-oxa-10-Phosphaphenanthren-10-Oxid, einer Phenoxyphosphazen-Verbindung, einem Phosphat, einem Polyphosphat, einem Polyphosphonat und Phosphonat-Carbonat-Copolymeren ausgewählt worden sind.

5. Halogenfreie in Wärme aushärtende Harzzusammensetzung nach einem der Ansprüche 1 bis 4, **dadurch gekennzeichnet, dass** die halogenfreie in Wärme aushärtende Harzzusammensetzung ferner (E) einen Härtungsbeschleuniger aufweist,
wobei bevorzugt der Härtungsbeschleuniger aus einer Substanz oder aus einer Mischung von mindestens zwei Substanzen ausgewählt worden ist, die aus Imidazolverbindungen, Derivaten von Imidazolverbindungen, Piperidinen, einer Lewissäure und einem Triphenylphosphin ausgewählt worden sind,
wobei bevorzugt die Imidazolverbindungen aus einer Substanz oder aus einer Mischung von mindestens zwei Substanzen ausgewählt worden sind, die aus einem 2-Methylimidazol, einem 2-Ethyl-4-Methylimidazol, einem 2-Phenylimidazol und einem 2-Undecylimidazol ausgewählt worden sind,
wobei bevorzugt die Piperidine aus einer Substanz oder aus einer Mischung von mindestens zwei Substanzen ausgewählt worden sind, die aus einem 2,3-Diamino-Piperidin, einem 2,5-Diamino-Piperidin, einem 2,6-Diamino-Piperidin, einem 2-Amino-3-Methylpiperidin, einem 2-Amino-4-Methylpiperidin, einem 2-Amino-3-Nitropiperidin, einem 2-Amino-5-Nitropiperidin und einem 2-Amino-4,4-Dimethylpiperidin ausgewählt worden sind,
wobei bevorzugt bezogen auf 100 Gewichtsteilen der hinzugefügten Menge der Summe der Komponenten (A), (B), (C) und (D) die Komponente (E) in einer Menge von 0,01 bis 1 Gewichtsteilen, bevorzugt in einer Menge von 0,05 bis 0,8 Gewichtsteilen und besonders bevorzugt in einer Menge von 0,05 bis 0,6 Gewichtsteilen hinzugefügt wird.

6. Halogenfreie in Wärme aushärtende Harzzusammensetzung nach einem der Ansprüche 1 bis 5, **dadurch gekennzeichnet, dass** die halogenfreie in Wärme aushärtende Harzzusammensetzung ferner (F) einen Füllstoff enthält,
wobei bevorzugt der Füllstoff aus organischen Füllstoffen und anorganischen Füllstoffen, bevorzugt aus anorganischen Füllstoffen, besonders bevorzugt aus oberflächenbehandelten anorganischen Füllstoffen und am meisten bevorzugt aus oberflächenbehandelten Siliziumdioxid ausgewählt worden ist,
wobei bevorzugt das oberflächenbehandelte Oberflächenbehandlungsmittel aus einer Substanz oder aus einer Mischung von mindestens zwei Substanzen ausgewählt worden ist, die aus einem Silankopplungsmittel, einem Siliziumoligomer und einem Titanatkopplungsmittel ausgewählt worden ist,
wobei bevorzugt bezogen auf 100 Gewichtsteile der anorganischen Füllstoffe, das Oberflächenbehandlungsmittel in einer Menge von 0,1 bis 5,0 Gewichtsteilen, bevorzugt in einer Menge von 0,5 bis 3,0 Gewichtsteilen und besonders bevorzugt in einer Menge von 0,75 bis 2,0 Gewichtsteilen vorliegt,
wobei bevorzugt die anorganischen Füllstoffe aus einer Substanz oder aus einer Mischung von mindestens zwei Substanzen ausgewählt worden sind, die aus Nichtmetalloxiden, Metallnitriden, Nichtmetallnitriden, anorganischen Hydraten, anorganischen Salzen, Metallhydraten und einem anorganischen Phosphor und besonders bevorzugt aus einem von oder aus der Mischung aus mindestens zwei von einem geschmolzenen Siliziumdioxid, einem kristallinen Siliziumdioxid, einem kugelförmigen Siliziumdioxid, Hohlkieselsäure, einem Aluminiumhydroxid, einem Aluminiumoxid, einem Talk, einem Aluminiumnitrid, einem Bornitrid, einem Siliziumcarbid, Bariumsulfat, einem Bariumtitanat, einem Strontiumtitanat, einem Calciumcarbonat, einem Calciumsilikat und einem Glimmer ausgewählt worden sind,
wobei bevorzugt sind die organischen Füllstoffe aus einer Substanz oder aus einer Mischung von mindestens zwei Substanzen ausgewählt worden sind, die aus einem Polytetrafluorethylenpulver, einem Polyphenylensulfid und einem Polyethersulfonpulver ausgewählt worden sind,
wobei bevorzugt haben die Füllstoffe einen mittleren Teilchendurchmesser von 0,01 bis 50 µm, bevorzugt von 0,01 bis 20 µm und besonders bevorzugt von 0,1 bis 10 µm aufweisen,
wobei bevorzugt bezogen auf 100 Gewichtsteile der hinzugefügten Menge der Summe der Komponenten (A), (B), (C) und (D) die Komponente (F) in einer Menge von 5 bis 300 Teilen Gewichtsteilen, bevorzugt in einer Menge von 5 bis 200 Gewichtsteilen und besonders bevorzugt in einer Menge von 5 bis 150 Gewichtsteilen hinzugefügt wird.

7. Vorimprägnierte Faser, die ein Verstärkungsmaterial und eine halogenfreie in Wärme aushärtende Harzzusammensetzung nach einem der Ansprüche 1 bis 6 aufweist, das nach einem Imprägnieren und einem Trocknen daran befestigt worden ist.

8. Laminat mit mindestens einer vorimprägnierten Faser nach Anspruch 7.

9. Halogenfreie Hochfrequenz-Leiterplatte, die mindestens eine vorimprägnierte Faser nach Anspruch 7 und Metallfolien aufweist, die auf einer Seite oder auf zwei Seiten der laminierten vorimprägnierten Faser beschichtet sind.

## Revendications

1. Composition de résine thermodurcissable sans halogène, comprenant, sur la base de 100 parties en poids de solides organiques,
(A) de 30 à 60 parties en poids d'une résine époxy sans halogène ;
(B) de 5 à 30 parties en poids d'un premier agent durcissant de bisphénol contenant du phosphore ;
(C) de 5 à 30 parties en poids d'un deuxième agent durcissant de novolac dicyclopentadiène ; et
(D) un agent ignifuge contenant du phosphore ;
dans laquelle le bisphénol contenant du phosphore a la structure suivante 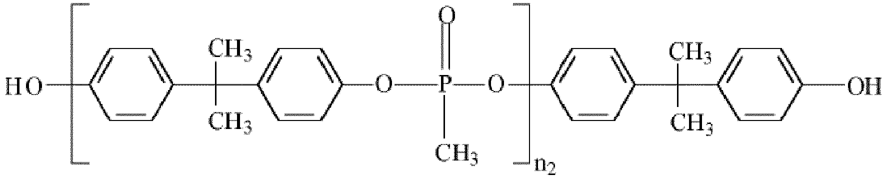 dans laquelle n₂ est un nombre entier de 2 à 20, de préférence, un nombre entier de 3 à 10 ;
de préférence, le bisphénol contenant du phosphore a un poids moléculaire moyen en poids de 1 000 à 6 500, de préférence de 1 000 à 4 500, de manière davantage préférée, de 1 000 à 3 000.

2. Composition de résine thermodurcissable sans halogène selon la revendication 1, **caractérisée en ce que** la résine époxy sans halogène est l'une choisie parmi ou dans le mélange d'au moins deux parmi une résine époxy bisphénol A, une résine époxy bisphénol F, une résine époxy novolac o-crésol, une résine époxy novolac bisphénol, une résine époxy novolac trisphénol, une résine novolac dicyclopentadiène, une résine époxy novolac biphényle, une résine époxy novolac alkylbenzène et une résine époxy novolac naphtol ;
de préférence, la résine époxy sans halogène est choisie dans la résine époxy ayant la structure suivante, 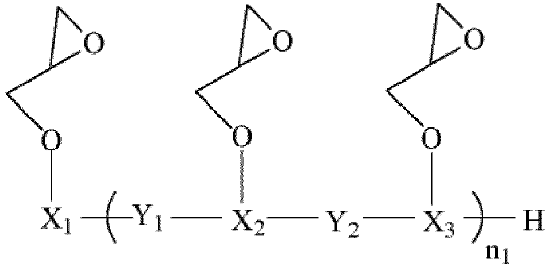 dans laquelle, X₁, X₂ et X₃ sont choisis chacun indépendamment parmi 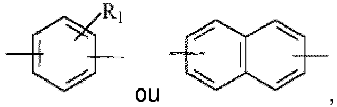 R₁ est choisi parmi un atome d'hydrogène, un groupe alkyle linéaire en C1 à C5 substitué ou non substitué, et un groupe alkyle ramifié en C1 à C5, substitué ou non substitué ;
Y₁ et Y₂ sont chacun indépendamment choisis parmi des liaisons simples, -CH₂-, 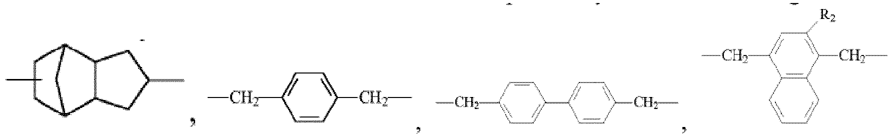 et 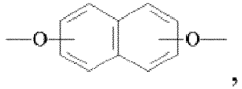 dans laquelle n₁ est un nombre entier de 1 à 10 ; R₂ est choisi parmi un atome d'hydrogène, un groupe alkyle linéaire en C1 à C5 substitué ou non substitué, et un groupe alkyle ramifié en C1 à C5 substitué ou non substitué.

3. Composition de résine thermodurcissable sans halogène selon la revendication 1 ou 2, **caractérisée en ce que** le novolac dicyclopentadiène a la structure suivante 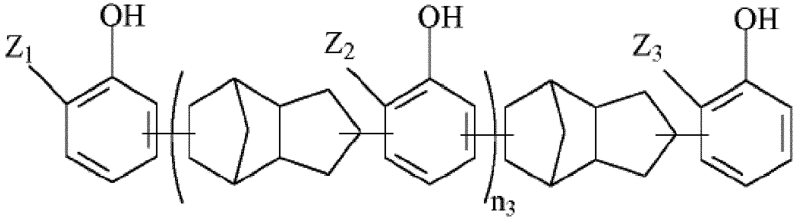 dans laquelle Z₁, Z₂ et Z₃ sont indépendamment choisis parmi -H, -CH₃, -C₂H₅ et -C(CH₃)₃ ; n₃ est un nombre entier de 0 à 7.

4. Composition de résine thermodurcissable sans halogène selon l'une des revendications 1 à 3, **caractérisée en ce que**, sur la base de 100 parties en poids de la quantité d'addition du total des composants (A), (B) et (C), le composant (D) est ajouté en une quantité de 5 à 50 parties en poids, de préférence de 10 à 30 parties en poids ;
de préférence, l'agent ignifuge contenant du phosphore est l'un choisi parmi ou dans le mélange d'au moins deux choisis parmi
la tri-(2,6-diméthylphényl)-phosphine, le 10-(2,5-dihydroxyphényl)-9,10-dihydro-9-oxa-10-phosphaphénanthrène-10-oxyde, le 2,6-di-(2,6-diméthylphényl)phosphine benzène, le 10-phényl-9,10-dihydro-9-oxa-10-phosphapénanthrène-10-oxyde, le composé phénoxyphosphazène, le phosphate, le polyphosphate, le polyphosphonate et les copolymères de phosphonate-carbonate.

5. Composition de résine thermodurcissable sans halogène selon l'une des revendications 1 à 4, **caractérisée en ce que** la composition de résine thermodurcissable sans halogène comprend en outre (E) un accélérateur de durcissement ;
de préférence, l'accélérateur de durcissement est l'un choisi parmi ou dans le mélange d'au moins deux choisis parmi des composés imidazole, des dérivés de composés imidazole, des pipéridines, un acide de Lewis et de la triphénylphosphine ;
de préférence, les composés imidazole sont l'un choisi parmi ou dans le mélange d'au moins deux choisis parmi le 2-méthylimidazole, le 2-éthyl-4-méthylimidazole, le 2-phénylimidazole et le 2-undécylimidazole ;
de préférence, les pipéridines sont choisies parmi ou dans le mélange d'au moins deux choisies parmi la 2,3-diamino-pipéridine, la 2,5- diamino-pipéridine, la 2,6-diamino-pipéridine, la 2-amino-3-méthylpipéridine, la 2-amino-4-méthyl-pipéridine, la 2-amino-3-nitro-pipéridine, la 2-amino-5-nitro-pipéridine et la 2-amino-4,4-diméthyl-pipéridine ;
de préférence, sur la base de 100 parties en poids de la quantité d'addition du total des composants (A), (B), (C) et (D), le composant (E) est ajouté en une quantité de 0,01 à 1 partie en poids, de préférence de 0,05 à 0,8 partie en poids, de manière davantage préférée, de 0,05 à 0,6 partie en poids.

6. Composition de résine thermodurcissable sans halogène selon l'une des revendications 1 à 5, **caractérisée en ce que** la composition de résine thermodurcissable sans halogène comprend en outre (F) un agent de charge ;
de préférence, l'agent de charge est choisi parmi des agents de charge organiques et des agents de charge inorganiques, de préférence des agents de charge inorganique, de manière davantage préférée, des agents de charge inorganiques traités en surface, de manière préférée entre tous, de la silice traitée en surface,
de préférence, l'agent de traitement de la surface traitée en surface est l'un choisi parmi ou dans le mélange d'au moins deux choisis parmi un agent de couplage du silane, un oligomère de silicone et un agent de couplage du titanate ;
de préférence, sur la base de 100 parties en poids des agents de charge inorganiques, l'agent de traitement de la surface est en une quantité de 0,1 à 5,0 partie en poids, de préférence de 0,5 à 3,0 partie en poids, de manière davantage préférée, de 0,75 à 2,0 parties en poids ;
de préférence, les agents de charge inorganiques sont l'un choisi parmi ou dans le mélange d'au moins deux choisis parmi les oxydes non métalliques, les nitrures métalliques, les nitrures non métalliques, les hydrates inorganiques, les sels inorganiques, les hydrates métalliques et le phosphore inorganique, de manière davantage préférée, sont l'un choisi parmi ou dans le mélange d'au moins deux choisis parmi la silice fondue, la silice cristalline, la silice sphérique, la silice creuse, l'hydroxyde d'aluminium, l'alumine, le talc, le nitrure d'aluminium, le nitrure de bore, le carbure de silicium, le sulfate de baryum, le titanate de baryum, le titanate de strontium, le carbonate de calcium, le silicate de calcium et le mica ;
de préférence, les agents de charge organiques sont l'un choisi parmi ou dans le mélange de deux choisis parmi la poudre de polytétrafluoroéthylène, les poudres de sulfure de polyphénylène et de polyéther sulfone ;
de préférence, les agents de charge ont un diamètre de particule médian de 0,01 à 50 µm, de préférence, de 0,01 à 20 µm, de manière davantage préférée, de 0,1 à 10 µm ;
de préférence, sur la base de 100 parties en poids de la quantité d'addition du total des composants (A), (B), (C) et (D), et le composant (F) est ajouté en une quantité de 5 à 300 parties en poids, de préférence de 5 à 200 parties en poids, de manière davantage préférée, de 5 à 150 parties en poids.

7. Pré-imprégné comprenant un matériau de renforcement et une composition de résine thermodurcissable sans halogène selon l'une quelconque des revendications 1 à 6, qui est fixée sur celui-ci après imprégnation et séchage.

8. Stratifié comprenant au moins un pré-imprégné selon la revendication 7.

9. Circuit imprimé à haute fréquence sans halogène, comprenant au moins un pré-imprégné selon la revendication 7 et des films métalliques appliqués sur l'une ou les deux faces du pré-imprégné stratifié.
